# EUROPEAN PATENT SPECIFICATION

(11) **EP 2 716 710 B1**
(45) Date of publication and mention of the grant of the patent: **27.02.2019**
(21) Application number: 12793957.7
(22) Date of filing: 16.05.2012
(51) Int. Cl.: C08L 63/00, C08G 59/20, C08J 5/24, C08K 3/22, C08L 79/08, H05K 1/03

(54) **RESIN COMPOSITION AND PREPREG AND METAL FOIL CLAD LAMINATE USING SAME**
HARZZUSAMMENSETZUNG SOWIE PREPREG UND METALLFOLIENBESCHICHTUNGSSTOFF DAMIT
COMPOSITION DE RÉSINE ET STRATIFIÉ PRÉ-IMPRÉGNÉ ET REVÊTEMENT DE FEUILLE MÉTALLIQUE L'UTILISANT

(30) Priority: 31.05.2011 JP 2011121924
(43) Date of publication of application: 09.04.2014
(73) Proprietor: Mitsubishi Gas Chemical Company, Inc., Tokyo 100-8324 (JP)
(72) Inventor: MORISHITA, Koji, Tokyo 125-8601 (JP); KOIZUMI, Kaoru, Tokyo 125-8601 (JP); TAKADA, Keisuke, Tokyo 125-8601 (JP)
(74) Representative: Hoffmann Eitle
(86) International application number: PCT/JP2012/062516
(87) International publication number: WO 2012/165147

(56) References cited:
- WO-A1-2004/072150
- WO-A1-2009/078129
- JP-A- 2 155 950
- JP-A- 61 021 139
- JP-A- 2007 138 002
- JP-A- 2007 231 125
- JP-A- 2008 094 927
- JP-A- 2008 274 004
- JP-A- 2008 297 536
- JP-A- 2010 037 442
- JP-A- 2011 005 714
- JP-A- 2011 035 110
- JP-A- 2011 093 966
- 'Data Sheet W216, BYK Japan Kabushiki Kaisha' DISPERBYK-110, DISPERBYK-11 2008, XP008173865 Retrieved from the Internet: <URL:http://www.byk.co.jp/datasheet/data/pd f/W216.pdf> [retrieved on 2012-08-03]
- 'Data Sheet W208, BYK Japan Kabushiki Kaisha' DISPERBYK-180 2008, XP055157810 Retrieved from the Internet: <URL:http://www.byk.co.jp/datasheet/data/pd f/W208.pdf> [retrieved on 2012-08-03]
- 'Data Sheet W510, BYK Japan Kabushiki Kaisha' BYK-W996 2008, XP008173866 Retrieved from the Internet: <URL:http://www.byk.co.jp/datasheet/data/pd f/W510_.pdf> [retrieved on 2012-08-03]
- 'Data Sheet W508, BYK Japan Kabushiki Kaisha' BYK-W903 2008, XP008173867 Retrieved from the Internet: <URL:http://www.byk.co.jp/datasheet/data/pd f/W508.pdf> [retrieved on 2012-08-03]

## Description

### Technical Field

The present invention relates to a resin composition, and a prepreg and a metal foil-clad laminate using the same. In particular, the present invention relates to a resin composition, a prepreg, and a metal foil-clad laminate, which can be used suitably for a printed wiring board material, especially, a light emitting diode (LED)-mounting printed wiring board.

### Background Art

Conventionally, a laminate (for example, see Patent Literature 1) or the like obtained by impregnating a glass woven fabric with an epoxy resin containing titanium dioxide and thereafter curing the impregnated glass woven fabric by heating has been known as an LED-mounting printed wiring board. However, because this type of laminate using the epoxy resin usually has low heat resistance, the surface of a substrate of such a laminate is discolored by a heat treatment in a producing process and LED-mounting process of a printed wiring board, and heating or light irradiation when used after LED-mounting, which may cause a problem that reflectance is remarkably decreased.

Because LEDs emitting short-wavelength light such as blue light and white light have become more general in recent years, a laminate having particularly excellent heat resistance and light resistance has been demanded for the laminate used in the LED-mounting printed wiring board. Therefore, a prepreg which is made of a resin composition containing a bisphenol A novolac-based epoxy resin (A), an alicyclic epoxy resin (B), and titanium dioxide (C), and a base material, or the like is proposed as a copper-clad laminate which has excellent heat resistance, exhibits high optical reflectance in the ultraviolet light region and the visible light region, and undergoes less deterioration in optical reflectance when subjected to a heat treatment or a light irradiation treatment (for example, see Patent Literature 2).

On the other hand, a silicone lamination substrate has been known to have excellent mechanical properties, heat resistance, and color fastness, have less tack on the surface, and undergo less deterioration in optical reflectance when subjected to heating and light irradiation (for example, see Patent Literature 3). The silicone laminated substrate is prepared by impregnating a glass cloth with an addition-curable silicone resin composition containing organopolysiloxane and organohydrogenpolysiloxane which have a specific resin structure, a platinum group metal-based catalyst, and a filler, and curing the impregnated glass cloth by heat.

Patent literature 4 discloses a thermosetting resin composition for prepregs and flexible printed wiring boards comprising a polyimide resin, an epoxy resin, and epoxy hardener components.

### Citation List

### Patent Literature

Patent Literature 1: Japanese Patent Laid-Open No. 10-202789
Patent Literature 2: Japanese Patent Laid-Open No. 2008-001880
Patent Literature 3: Japanese Patent Laid-Open No. 2010-089493
Patent Literature 4: Japanese Patent Laid-Open No. 2007-231125

### Summary of Invention

### Technical Problem

However, the brightness and the output of the LED get progressively increased, and the field of application of the LED further extends to large display applications such as television and home lighting applications from previous miniaturized display applications such as a mobile phone and car navigation. Therefore, a laminate having a further improved performance to discoloration and deterioration caused by heat or light as compared with that of the conventional laminate has been demanded.

Especially, high adhesion (peel strength) between a laminate for printed wiring boards and a metal foil that is laminated when the laminate for printed wiring boards is used as a metal foil-clad laminate is demanded. Furthermore, when a reflow is performed using unleaded solder, high heat resistance is demanded. However, a resin composition which can realize a printed wiring board excellent in all the characteristics is not yet developed.

The present invention has been made in view of the above problems. It is an object of the present invention to provide a resin composition which has high optical reflectance in the ultraviolet light region and the visible light region, undergoes less deterioration in optical reflectance when subjected to a heat treatment and a light irradiation treatment, has an improved peel strength to a metal foil, and has excellent heat resistance; and a prepreg and a metal foil-clad laminate using the resin composition.

### Solution to Problem

The present inventors have diligently studied in order to solve the problems. As a result, the inventors found that a prepreg and a metal foil-clad laminate which exhibit high optical reflectance in an ultraviolet light region and a visible light region, undergo less deterioration in optical reflectance when subjected to a heat treatment and a light irradiation treatment, have an improved peel strength to a metal foil, and have excellent heat resistance are obtained by using a resin composition comprising at least an aliphatic epoxy-modified silicone compound, a multibranched imide resin having an isocyanurate ring and a carboxyl group, titanium dioxide, and a dispersing agent, thereby completing the invention.

That is, the present invention provides the following [1] to [13].
[1] A resin composition comprising:
   an aliphatic epoxy-modified silicone compound (A);
   a multibranched imide resin (B) having an isocyanurate ring and a carboxyl group;
   titanium dioxide (C); and
   a dispersing agent (D).
[2] The resin composition according to [1], wherein the aliphatic epoxy-modified silicone compound (A) is a silicone compound having a repeating unit represented by the following formula (1), having at least three R's per molecule, and containing no alkoxy group: 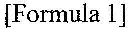 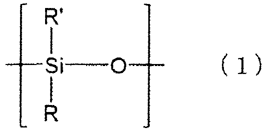 wherein R is a hydrogen atom, or a substituted or unsubstituted univalent hydrocarbon group, and R' is an organic group having an epoxy group.
[3] The resin composition according to [1] or [2], wherein the multibranched imide resin (B) is represented by the following formula (6): 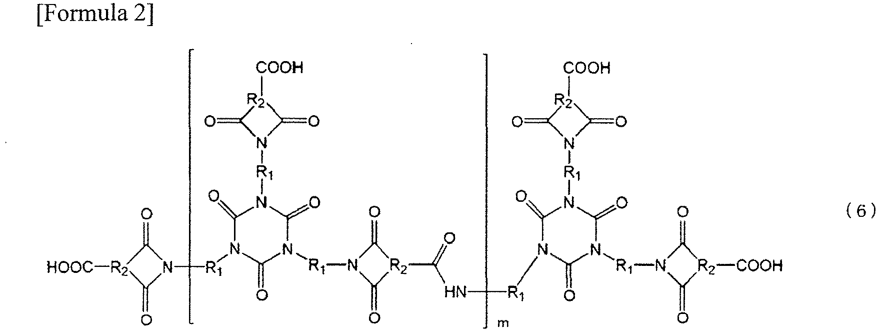 wherein each R₁ is independently a divalent alicyclic group; each R₂ is independently a trivalent alicyclic group; and m is an integer of 1 to 10.
[4] The resin composition according to any one of [1] to [3], wherein a content of the aliphatic epoxy-modified silicone compound (A) is 20 to 90 parts by mass based on 100 parts by mass in total of the aliphatic epoxy-modified silicone compound (A) and the multibranched imide resin (B).
[5] The resin composition according to any one of [1] to [4], wherein a content of the multibranched imide resin (B) is 10 to 80 parts by mass based on 100 parts by mass in total of the aliphatic epoxy-modified silicone compound (A) and the multibranched imide resin (B).
[6] The resin composition according to any one of [1] to [5], wherein a content of the titanium dioxide (C) is 10 to 250 parts by mass based on 100 parts by mass in total of the aliphatic epoxy-modified silicone compound (A) and the multibranched imide resin (B).
[7] The resin composition according to any one of [1] to [6], wherein a mean particle diameter of the titanium dioxide (C) is 5 µm or less.
[8] The resin composition according to any one of [1] to [7], wherein the titanium dioxide (C) is surface-treated with SiO₂, Al₂O₃, ZrO₂, and/or ZnO; and the total amount of 100 parts by mass of the titanium dioxide (C) comprises 0.5 to 15 parts by mass of SiO₂, 0.5 to 15 parts by mass of Al₂O₃, 0.5 to 15 parts by mass of ZrO₂, and/or 0.5 to 15 parts by mass of ZnO.
[9] The resin composition according to any one of [1] to [8], wherein the dispersing agent (D) is a polymer wet dispersing agent having an acid value of 20 to 200 mgKOH/g.
[10] The resin composition according to any one of [1] to [9], wherein a content of the dispersing agent (D) is 0.05 to 5 parts by mass based on 100 parts by mass in total of the aliphatic epoxy-modified silicone compound (A) and the multibranched imide resin (B).
[11] The resin composition according to any one of [1] to [10] for an LED-mounting printed wiring board.
[12] A prepreg prepared by impregnating or coating a base material with the resin composition according to any one of [1] to [11].
[13] A metal foil-clad laminate obtained by stacking one or more prepregs according to [12], disposing a metal foil on one side or both sides of the stack, and laminate-molding the one or more prepregs and the metal foil.

### Advantageous Effects of Invention

The prepreg and the metal foil-clad laminate which exhibit high optical reflectance in an ultraviolet light region and a visible light region, undergo less deterioration in optical reflectance when subjected to a heat treatment and a light irradiation treatment, have an improved peel strength to a metal foil, and have excellent heat resistance can be simply and certainly achieved with good reproducibility by using the resin composition of the present invention. Therefore, the resin composition, the prepreg, and the metal foil-clad laminate according to the present invention can be used suitably for the LED-mounting printed wiring board or the like, and have extremely high industrial practicality.

### Description of Embodiment

Hereinafter, an embodiment of the present invention will be described. The following embodiment is illustrative in order to describe the present invention. The present invention is not limited only to the embodiment.

A resin composition of the present embodiment is a so-called heat-curable resin composition cured by heat. The resin composition comprises an aliphatic epoxy-modified silicone compound (A), a multibranched imide resin (B) having an isocyanurate ring and a carboxyl group, titanium dioxide (C), and a dispersing agent (D).

The aliphatic epoxy-modified silicone compound (A) used in the present embodiment is obtained by introducing a substituted or unsubstituted aliphatic hydrocarbon group having an epoxy group into a silicone compound having a siloxane bond (Si-O-Si bond) as a main skeleton. The use of the aliphatic epoxy-modified silicone compound (A) with the multibranched imide resin (B), the titanium dioxide (C), and the dispersing agent (D) tends to improve optical reflectance in an ultraviolet light region and a visible light region, suppress the deterioration in optical reflectance when subjected to a heat treatment and a light irradiation treatment, and especially improve a peel strength to a metal foil, and heat resistance.

The aliphatic epoxy-modified silicone compound (A) is preferably a silicone compound which has a repeating unit represented by the following formula (1), has at least three R's per molecule, and does not contain an alkoxy group. Particularly, in view of excellent workability, the aliphatic epoxy-modified silicone compound (A) is preferably a liquid. Herein, having the repeating unit represented by the following formula (1) includes both having a plurality (preferably, 3 or more) of the same units having the same R and R' and having a plurality (preferably, 3 or more) of units having different R and R' in a connotative sense. 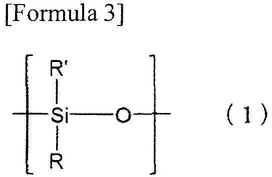 wherein R is a hydrogen atom, or a substituted or unsubstituted univalent hydrocarbon group, and R' is an organic group having an epoxy group.

In the formula (1), specific examples of the univalent hydrocarbon group represented by R include a substituted or unsubstituted aliphatic hydrocarbon group. The univalent hydrocarbon group preferably has 1-20 carbon atoms, and more preferably 1-8 carbon atoms. More specifically, examples thereof include, but are not particularly limited to, alkyl groups such as a methyl group, an ethyl group, a propyl group, a butyl group, a hexyl group, and an octyl group; and groups in which a portion or all of hydrogen atoms of these univalent hydrocarbon groups are replaced with a glycidyl group (excluding an epoxycyclohexyl group), a methacrylic group, an acrylic group, a mercapto group, and an amino group or the like. Among them, R is preferably the methyl group, the ethyl group, and the hydrogen atom, and more preferably the methyl group.

Specific examples of the organic group having the epoxy group represented by R' in the formula (1) include a substituted or unsubstituted aliphatic hydrocarbon group having an epoxy group. The organic group preferably has 1-20 carbon atoms, and more preferably 1-12 carbon atoms. More specifically, examples thereof include, but are not particularly limited to, a glycidoxy propyl group and a 3,4-epoxycyclohexyl ethyl group. Particularly, from the viewpoint of small curing shrinkage, R' is preferably the organic group having the 3,4-epoxycyclohexyl group.

The silicone compound having the repeating unit represented by the formula (1) preferably has 3-8 R's per molecule. When the silicone compound having the unit represented by the formula (1) has R's of the range, a cured product having a high hardness and excellent toughness tends to be easily obtained.

The silicone compound having the repeating unit represented by the formula (1) preferably has a polymerization degree of 3 to 100. Because the silicone compound having the polymerization degree of the range is easily and industrially synthesized, the silicone compound is readily available. From the viewpoint of being capable of further suppressing the curing shrinkage in addition to these characteristics, the polymerization degree is more preferably 3 to 50, and still more preferably 3 to 10.

The silicone compound having the repeating unit represented by the formula (1) does not contain the alkoxy group. Therefore, the silicone compound is not cured and shrunk by a dealcoholization reaction. When the silicone compound is used in combination with the multibranched imide resin (B), excellent dielectric breakdown characteristics can be obtained.

Specific examples of the silicone compound having the repeating unit represented by the formula (1) include a silicone compound having a straight chain structure or a ring structure.

Examples of the silicone compound having the ring structure include a cyclic silicone compound represented by the following formula (2). The cyclic silicone compound represented by the formula (2) is suitable in view of small curing shrinkage: 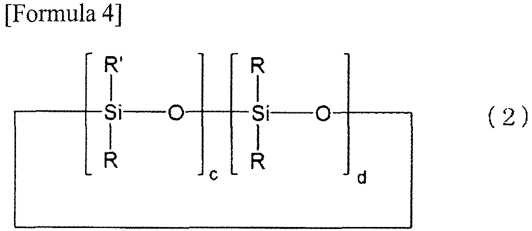 wherein R and R' in the formula (2) are synonymous with those in the formula (1); c represents an integer of 3 to 5; d represents an integer of 0 to 2; the sum of c and d is an integer of 3 to 5; and each polymerization unit can be randomly polymerized.

In the formula (2), preferably, c is an integer of 3 to 4; d is an integer of 0 to 1; and the sum of c and d is 4.

Among the cyclic silicone compounds represented by the formula (2), a cyclic silicone compound represented by the following formula (2') is more preferable: 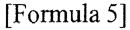 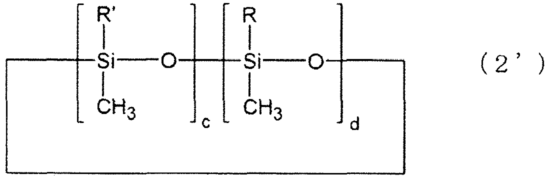 wherein R, R', c, and d are synonymous with those described above.

Examples of the silicone compound having the straight chain structure include a straight-chain silicone compound represented by the following formula (3): 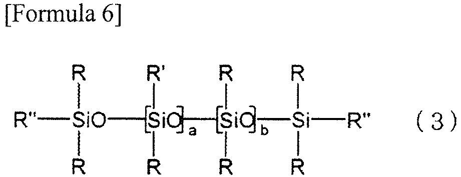 wherein R and R' are synonymous with those in the formula (1); R" represents R or R'; R, R', and R" may be the same or different; a represents an integer of 1 to 10; b represents an integer of 0 to 8; the sum of a and b is an integer of 2 to 10; R"s of both terminals are R's when a = 1 is set; at least one of R"s is R' when a = 2 is set; and each polymerization unit can be randomly polymerized.

In the formula (3), preferably, a is an integer of 4 to 8; b is an integer of 0 to 4; and the sum of a and b is 4 to 8.

Among the straight-chain silicone compounds represented by the formula (3), a straight-chain silicone compound represented by the following formula (3') is more preferable. 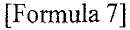 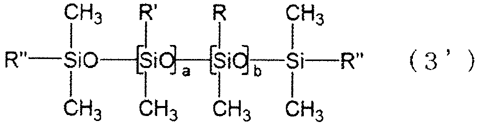 wherein R, R', R", a, and b are synonymous with those described above.

Among the straight-chain silicone compounds represented by the formula (3), a straight-chain silicone compound represented by the following formula (4) is still more preferable: 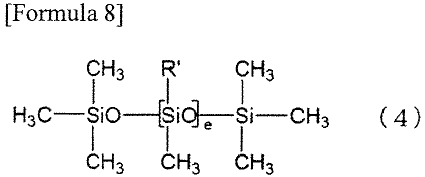 wherein R' is synonymous with that described above, and e represents an integer of 3 to 10.

In the formula (4), e is preferably an integer of 3 to 8.

The silicone compound having the repeating unit represented by the formula (1) is still more preferably a cyclic silicone compound represented by the following formula (5). 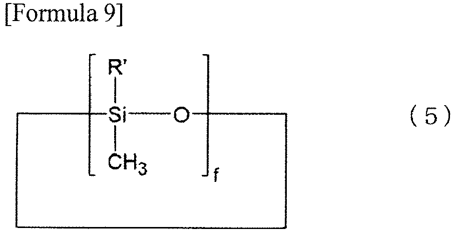 wherein R' is synonymous with that in the formula (1), and f represents an integer of 3 to 5.

In the formula (5), f is preferably 4.

The aliphatic epoxy-modified silicone compound (A) particularly preferably contains 50% by mass or more of a compound in which f is 4 in the formula (5).

Specific examples of the aliphatic epoxy-modified silicone compound (A) include, but are not particularly limited to, (CH₃)₃SiO(R'CH₃SiO)₅Si(CH₃)₃,
(CH₃)₃SiO(R'CH₃SiO)₆Si(CH₃)₃, (CH₃)₃SiO(R'CH₃SiO)₇Si(CH₃)₃,
(CH₃)₃SiO(R'CH₃SiO)₈Si(CH₃)₃, (CH₃)₃SiO(R'CH₃SiO)₉Si(CH₃)₃,
(CH₃)₃SiO(R'CH₃SiO)₁₀Si(CH₃)₃, R'(CH₃)₂SiO(R'CH₃SiO)Si(CH₃)₂R',
R'(CH₃)₂SiO(R'CH₃SiO)₂Si(CH₃)₂R', R'(CH₃)₂SiO(R'CH₃SiO)₃Si(CH₃)₂R',
R'(CH₃)₂SiO(R'CH₃SiO)₄Si(CH₃)₂R', R'(CH₃)₂SiO(R'CH₃SiO)₅Si(CH₃)₂R',
R'(CH₃)₂SiO(R'CH₃SiO)₆Si(CH₃)₂R', R'(CH₃)₂SiO(R'CH₃SiO)₇Si(CH₃)₂R',
R'(CH₃)₂SiO(R'CH₃SiO)₈Si(CH₃)₂R', R'(CH₃)₂SiO(R'CH₃SiO)₉Si(CH₃)₂R',
R'(CH₃)₂SiO(R'CH₃SiO)₂((CH₃)₂SiO)₂Si(CH₃)₂R',

R'(CH₃)₂SiO(R'CH₃SiO)₃((CH₃)₂SiO)Si(CH₃)₂R',
R'(CH₃)₂SiO(R'CH₃SiO)₃((CH₃)₂SiO)₂Si(CH₃)₂R',

R'(CH₃)₂SiO(R'CH₃SiO)₄((CH₃)₂SiO)Si(CH₃)₂R',
R'(CH₃)₂SiO(R'CH₃SiO)₄((CH₃)₂SiO)₂Si(CH₃)₂R',
R'(CH₃)₂SiO(R'CH₃SiO)₅((CH₃)₂SiO)Si(CH₃)₂R',
R'(CH₃)₂SiO(R'CH₃SiO)₅((CH₃)₂SiO)₂Si(CH₃)₂R',
R'(CH₃)₂SiO(R'CH₃SiO)₅((CH₃)₂SiO)₃Si(CH₃)₂R',
R'(CH₃)₂SiO(R'CH₃SiO)₆((CH₃)₂SiO)Si(CH₃)₂R',

R'(CH₃)₂SiO(R'CH₃SiO)₆((CH₃)₂SiO)₂Si(CH₃)₂R',
R'(CH₃)₂SiO(R'CH₃SiO)₆((CH₃)₂SiO)₃Si(CH₃)₂R',
R'(CH₃)₂SiO(R'CH₃SiO)₇((CH₃)₂SiO)Si(CH₃)₂R',
R'(CH₃)₂SiO(R'CH₃SiO)₇((CH₃)₂SiO)₂Si(CH₃)₂R',
R'(CH₃)₂SiO(R'CH₃SiO)₇((CH₃)₂SiO)₃Si(CH₃)₂R',
R'(CH₃)₂SiO(R'CH₃SiO)₇((CH3)₂SiO)4Si(CH3)₂R',
R'(CH₃)₂SiO(R'CH₃SiO)₈((CH₃)₂SiO)Si(CH₃)₂R',
R'(CH₃)₂SiO(R'CH₃SiO)₈((CH₃)₂SiO)₂Si(CH₃)₂R',
R'(CH₃)₂SiO(R'CH₃SiO)₈((CH₃)₂SiO)₃Si(CH₃)₂R',

R'(CH₃)₂SiO(R'CH₃SiO)₄(R⁰CH₃SiO)Si(CH₃)₂R',
R'(CH₃)₂SiO(R'CH₃SiO)₅(R⁰CH₃SiO)Si(CH₃)₂R',
R'(CH₃)₂SiO(R'CH₃SiO)₆(R⁰CH₃SiO)Si(CH₃)₂R',
R'(CH₃)₂SiO(R'CH₃SiO)₇(R⁰CH₃SiO)Si(CH₃)₂R',
R'(CH₃)₂SiO(R'CH₃SiO)₈(R⁰CH₃SiO)Si(CH₃)₂R',
R'(CH₃)₂SiO(R'CH₃SiO)₉(R⁰CH₃SiO)Si(CH₃)₂R', (R'CH₃SiO)₃, (R'CH₃SiO)₄,
(R'CH₃SiO)₅, (R'CH₃SiO)₃((CH₃)₂SiO), and (R'CH₃SiO)₃(C₃H₇(CH₃)SiO). Herein, R' is synonymous with that described above, and R⁰ represents a methacryloxypropyl group. The aliphatic epoxy-modified silicone compounds (A) may be used singly or in combinations of two or more.

The aliphatic epoxy-modified silicone compound (A) can be produced by a known method. Specifically, for example, the aliphatic epoxy-modified silicone compound (A) can be obtained by addition reaction (hydrosilylating) of an allyl epoxy compound (for example, 4-vinylcyclohexene oxide) to organohydrogenpolysiloxane using a catalyst such as a platinum compound. Commercial items can also be used as the aliphatic epoxy-modified silicone compound (A). For example, X-40-2670 (manufactured by Shin-Etsu Chemical Co., Ltd.) and SE-02CM (manufactured by Nagase ChemteX Corporation) or the like are suitably used.

The content of the aliphatic epoxy-modified silicone compound (A) in the resin composition of the present embodiment is not particularly limited. The content of the aliphatic epoxy-modified silicone compound (A) is preferably 20 to 90 parts by mass, and more preferably 30 to 80 parts by mass, based on 100 parts by mass in total of the aliphatic epoxy-modified silicone compound (A) and the multibranched imide resin (B) in the resin composition. The content of the aliphatic epoxy-modified silicone compound (A) is set to be within the preferable range, and thereby the discoloration of a metal foil-clad laminate to be obtained, when subjected to a heat treatment and a light irradiation treatment tends to be further suppressed to more effectively suppress the deterioration in reflectance.

Any multibranched imide resin having an isocyanurate ring, a carboxyl group, and an imide group is used as the multibranched imide resin (B) used in the present embodiment without particular limitation. The multibranched imide resin (B) is preferably a multibranched imide resin having an isocyanurate ring and a plurality of cyclic imides having a carboxyl group, wherein many of the cyclic imides are bonded to the isocyanurate ring. The multibranched imide resin (B) is more preferably an imide resin having an alicycle structure, i.e., an alicyclic imide resin (which does not have an aromatic ring). Examples of the alicyclic imide resin include a multibranched alicyclic imide resin which has an isocyanurate ring and a plurality of aliphatic cyclic imides bonded to each nitrogen atom of the isocyanurate ring via an aliphatic ring and having a carboxylic acid group. The multibranched imide resin (B) having the isocyanurate ring and the carboxyl group is used with the aliphatic epoxy-modified silicone compound (A), the titanium dioxide (C), and the dispersing agent (D). This use tends to especially improve a peel strength to the metal foil, and heat resistance, especially improve optical reflectance in the ultraviolet light region and the visible light region, and remarkably suppress the deterioration in optical reflectance when subjected to the heat treatment and the light irradiation treatment.

For example, a multibranched imide resin (trade name: V-8002 (manufactured by DIC Corporation)) represented by the following formula (6) can be used as the multibranched imide resin (B). 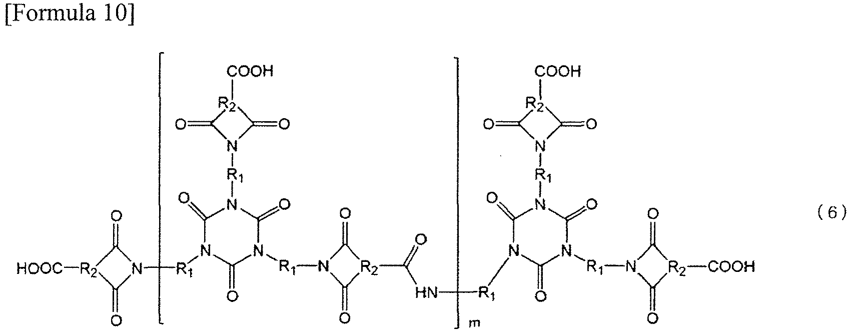 wherein each R₁ independently represents a divalent alicyclic group; each R₂ independently represents a trivalent alicyclic group; and m is an integer of 1 to 10.

The alicyclic group represented by R₁ in the formula (6) is a divalent group containing an aliphatic ring and preferably having 6-20 carbon atoms. The alicyclic group is a residue of an alicyclic diamine or an alicyclic diisocyanate as a raw material. Examples of the alicyclic diamine include, but are not particularly limited to, 4,4'-diamino-dicyclohexylmethane, 3,3'-dimethyl-4,4'-diamino-dicyclohexylmethane, 3,3'-diethyl-4,4'-diamino-dicyclohexylmethane, 3,3',5,5'-tetramethyl-4,4'-diamino-dicyclohexylmethane, 3,3',5,5'-tetraethyl-4,4'-diamino-dicyclohexylmethane, 3,5-diethyl-3',5'-dimethyl-4,4'-diaminodicyclohexylmethane, 1,4-cyclohexanediamine, 1,3-cyclohexanediamine, isophoronediamine, 2,2-bis[4-(4-aminocyclohexyloxy)cyclohexyl]propane, bis[4-(3-aminocyclohexyloxy)cyclohexyl]sulfone, bis[4-(4-aminocyclohexyloxy)cyclohexyl]sulfone, 2,2-bis[4-(4-aminocyclohexyloxy)cyclohexyl]hexafluoropropane, bis[4-(4-aminocyclohexyloxy)cyclohexyl]methane, 4,4'-bis(4-aminocyclohexyloxy)dicyclohexyl, bis[4-(4-aminocyclohexyloxy)cyclohexyl]ether, bis[4-(4-aminocyclohexyloxy)cyclohexyl]ketone, 1,3-bis(4-aminocyclohexyloxy)benzene, 1,4-bis(4-aminocyclohexyloxy)benzene, (4,4'-diamino)dicyclohexylether, (4,4'-diamino)dicyclohexylsulfone, (4,4'-diaminocyclohexyl)ketone,(3,3'-diamino)benzophenone, 2,2'-dimethylbicyclohexyl-4,4'-diamine, 2,2'-bis(trifluoromethyl)dicyclohexyl-4,4'-diamine, 5,5'-dimethyl-2,2'-sulfonyldicyclohexyl-4,4'-diamine, 3,3'-dihydroxydicyclohexyl-4,4'-diamine, (4,4'-diamino)dicyclohexylmethane, (4,4'-diamino)dicyclohexylether, (3,3'-diamino)dicyclohexylether, and 2,2-bis(4-aminocyclohexyl)propane. Examples of the alicyclic diisocyanate include an alicyclic diisocyanate in which an amino group of the alicyclic diamine is replaced with an isocyanate group.

In the formula (6), the alicyclic group represented by R₂ is a group containing an aliphatic ring and preferably having 6-20 carbon atoms. The alicyclic group is a residue of alicyclic tricarboxylic acid or an anhydride as a raw material. Examples of the alicyclic tricarboxylic acid include, but are not particularly limited to, cyclohexane-1,2,3-tricarboxylic acid, cyclohexane-1,2,4-tricarboxylic acid, cyclohexane-1,3,5-tricarboxylic acid, 5-methylcyclohexane-1,2,4-tricarboxylic acid, 6-methylcyclohexane-1,2,4-tricarboxylic acid, and 3-methylcyclohexane-1,2,4-tricarboxylic acid.

The acid value of the multibranched imide resin (B) is preferably 30 to 80 mg KOH/g, and more preferably 40 to 70 mg KOH/g, in terms of a solid content from the viewpoint of the solubility and curing characteristics or the like of the multibranched imide resin (B) to an organic solvent.

The multibranched imide resins (B) may be used singly or in combinations of two or more. The content of the multibranched imide resin (B) in the resin composition of the present embodiment is not particularly limited. The content of the multibranched imide resin (B) is preferably 10 to 80 parts by mass, and more preferably 20 to 70 parts by mass, based on 100 parts by mass in total of the aliphatic epoxy-modified silicone compound (A) and the multibranched imide resin (B). The content of the multibranched imide resin (B) is set to be within the preferable range, and thereby the peel strength to the metal foil and the heat resistance tend to be further improved without causing excessive deterioration in reflectance caused by the discoloration of the obtained metal foil-clad laminate when subjected to the heat treatment and the light irradiation treatment.

The resin composition of the present embodiment contains the titanium dioxide (C) as an indispensable inorganic filler. From the viewpoint of further improving the optical reflectance in the ultraviolet light region and the visible light region, titanium dioxide having a rutile or anatase crystal structure is preferable.

The mean particle diameter (D50) of the titanium dioxide (C) is not particularly limited. The mean particle diameter (D50) of the titanium dioxide (C) is preferably 5 µm or less, and more preferably 0.5 µm or less. The titanium dioxides (C) may be used singly or in combinations of two or more. For example, titanium dioxides having different particle size distributions and mean particle diameters may be used in a proper combination.

Herein, from the viewpoint of further improving the optical reflectance in the ultraviolet light region and the visible light region, the titanium dioxide (C) is preferably surface-treated with SiO₂, Al₂O₃, ZrO₂, and/or ZnO. In other words, the titanium dioxide (C) preferably has a covering layer containing SiO₂, Al₂O₃, ZrO₂, and/or ZnO. Furthermore, the titanium dioxide (C) is more preferably surface-treated with SiO₂, Al₂O₃, ZrO₂, and/or ZnO, and then subjected to a polyol treatment, a silane coupling agent treatment, and/or an amine treatment. In other words, the titanium dioxide (C) more preferably has a covering layer containing SiO₂, Al₂O₃, ZrO₂, and/or ZnO and subjected to a polyol treatment, a silane coupling agent treatment, and/or an amine treatment.

When the surface-treated titanium dioxide (C) is used, the titanium dioxide (C) preferably contains 0.5 to 15 parts by mass of SiO₂, 0.5 to 15 parts by mass of Al₂O₃, 0.5 to 15 parts by mass of ZrO₂, and/or 0.5 to 15 parts by mass of ZnO, and more preferably 1 to 11 parts by mass of SiO₂, 1 to 11 parts by mass of Al₂O₃, 1 to 11 parts by mass of ZrO₂, and/or 1 to 11 parts by mass of ZnO based on the total amount of 100 parts by mass of the titanium dioxide (C). The amount of the titanium dioxide (C) to be surface-treated is set to be within the preferable range, and thereby the discoloration when subjected to the heat treatment or the light irradiation treatment tends to be further suppressed to further suppress the deterioration in the optical reflectance without causing excessive deterioration in the optical reflectance in the ultraviolet light region and the visible light region. The titanium dioxide (C) more preferably contains 3 to 11 parts by mass of SiO₂ and 1 to 3 parts by mass of Al₂O₃ based on the total amount of 100 parts by mass of the titanium dioxide (C).

The content of the titanium dioxide (C) in the resin composition of the present embodiment is not particularly limited. The content of the titanium dioxide (C) is preferably 10 to 250 parts by mass, and more preferably 25 to 200 parts by mass, based on 100 parts by mass in total of the aliphatic epoxy-modified silicone compound (A) and the multibranched imide resin (B). The content of the titanium dioxide (C) is set to be within the preferable range, and thereby the characteristics and processability of the obtained metal foil-clad laminate tend to be more easily improved without causing excessive deterioration in the optical reflectance in the ultraviolet light region and the visible light region. Specifically, occurrence of breakage or crack caused by conveyance or the like when a printed wiring board and a chip LED are produced tends to be suppressed, and occurrence of a defect of breakage of a drill bit or a dicing blade or impossibility of processing tends to be suppressed in mechanical drill processing in the printed wiring board and dicing processing in the chip LED.

Any dispersion stabilizer used for coating materials may be suitably used as the dispersing agent (D) used in the resin composition of the present embodiment without particular limitation. Especially, the dispersing agent (D) is preferably a polymer wet dispersing agent having an acid radical, and more preferably a polymer wet dispersing agent having an acid value of 20 to 200 mgKOH/g. Specific examples thereof include, but are not particularly limited to, polymer wet dispersing agents manufactured by BYK Japan K.K. such as BYK-W161, BYK-W903, BYK-W940, BYK-W996, BYK-W9010, Disper-BYK110, Disper-BYK111, and Disper-BYK180. The dispersing agents (D) may be used singly or in combinations of two or more.

The content of the dispersing agent (D) in the resin composition of the present embodiment is not particularly limited. The content of the dispersing agent (D) is preferably 0.05 to 5 parts by mass, more preferably 0.1 to 4.0 parts by mass, and still more preferably 0.5 to 3.0 parts by mass, based on 100 parts by mass in total of the aliphatic epoxy-modified silicone compound (A) and the multibranched imide resin (B). The content of the dispersing agent (D) is set to be within the preferable range, and thereby heat resistance tends to be further improved, and the dispersibility of the resin in the resin composition with the titanium dioxide (C) and other inorganic filler as an optional ingredient to be described later tends to be further improved to suppress molding irregularity.

Furthermore, the resin composition of the present embodiment may contain epoxy resins (hereinafter "other epoxy resins") other than the aliphatic epoxy-modified silicone compound (A) as ingredients other than those listed above. Examples of the other epoxy resins include, but are not particularly limited to, bisphenol A-based epoxy resins, bisphenol E-based epoxy resins, bisphenol F-based epoxy resins, bisphenol S-based epoxy resins, bisphenol A novolac-based epoxy resins, phenol novolac-based epoxy resins, cresol novolac-based epoxy resins, biphenyl-based epoxy resins, naphthalene-based epoxy resins, anthracene-based epoxy resins, trifunctional phenol-based epoxy resins, tetrafunctional phenol-based epoxy resins, glycidyl ester-based epoxy resins, phenolaralkyl-based epoxy resins, aralkyl novolac-based epoxy resins, biphenylaralkyl-based epoxy resins, naphtholaralkyl-based epoxy resins, dicyclopentadiene-based epoxy resins, polyol-based epoxy resins, alicyclic epoxy resins, or halides thereof. The other epoxy resins may be used singly or in combinations of two or more.

The resin composition of the present embodiment may contain other inorganic fillers in addition to the titanium dioxide (C). Specific examples of the other inorganic fillers include, but are not particularly limited to, silicas such as natural silica, synthetic silica, fused silica, amorphous silica, and hollow silica, boehmite, molybdenum compounds such as molybdenum oxide and zinc molybdate, zinc borate, zinc stannate, alumina, zinc oxide, magnesium oxide, zirconium oxide, aluminium hydroxide, boron nitride, clay, kaolin, talc, calcined clay, calcined kaolin, calcined talc, mica, a silicone composite powder, a silicone resin powder, glass short fibers (including fine powders of glasses such as E-glass, T-glass, D-glass, S-glass, and Q-glass), hollow glass, and spherical glass. The other inorganic fillers may be used singly or in combinations of two or more.

The resin composition of the present embodiment may contain curing accelerators to properly adjust a curing speed if necessary. This type of curing accelerator is known in the art. For example, any curing accelerator commonly used as curing accelerators for epoxy resins and phenolic resins may be suitably used. Specific examples of the curing accelerator include, but are not particularly limited to, organometal salts of copper, zinc, cobalt, nickel, and platinum or the like, imidazoles and derivatives thereof, and tertiary amines. The curing accelerators may be used singly or in combinations of two or more.

Furthermore, the resin composition of the present embodiment may contain solvents if necessary. For example, when the organic solvents are used, the viscosity of the resin composition when the resin composition is prepared is lowered, to improve the handleability of the resin composition and the impregnatability of a glass cloth with the resin composition. Any solvent may be used without particular limitation as long as the mixture of the aliphatic epoxy-modified silicone compound (A) and the multibranched imide resin (B) can be dissolved therein. Specific examples thereof include, but are not particularly limited to, ketones such as acetone, methyl ethyl ketone, and methyl cellosolve, aromatic hydrocarbons such as toluene and xylene, amides such as dimethylformamide, and propylene glycol methyl ether and acetate thereof. The solvents may be used singly or in combinations of two or more.

Furthermore, the resin composition of the present embodiment may contain ingredients other than those listed above in such an extent that does not sacrifice desired properties of the resin composition. Examples of the optional formulation include various polymeric compounds such as heat-curable resins, thermoplastic resins, and oligomers or elastomers thereof, flame-retardant compounds, and various additives or the like other than those listed above. Any of them which are commonly used in the art may be used without particular limitation. Specific examples of the flame-retardant compounds include nitrogen-containing compounds such as melamine and benzoguanamine, and oxazine ring-containing compounds. Specific examples of the additives include ultraviolet absorbers, antioxidants, photopolymerization initiators, fluorescent brighteners, photosensitizers, dyes, pigments, thickeners, lubricants, antifoaming agents, dispersants, leveling agents, brighteners, polymerization inhibitors, and silane coupling agents. These optional formulations may be used singly or in combinations of two or more.

It is preferable that the resin composition of the present embodiment substantially contains only the aliphatic epoxy-modified silicone compound (A), the multibranched imide resin (B), the titanium dioxide (C), and the dispersing agent (D). Thus, the resin composition contains only the four ingredients (A) to (D), and thereby various performances tend to be exhibited with a good balance at a high dimension. Especially, the resin composition of the present embodiment can be sufficiently cured by heat even in an aspect which does not contain the catalyst because the carboxyl group in the molecular structure of the multibranched imide resin (B) has a curing-accelerating function in a curing reaction. In this case, the resin composition has an exceptional technical meaning in that disadvantages such as a decrease in moldability accompanied by use of the catalyst, occurrence of abnormality of external appearance, and occurrence of coloring due to the catalyst do not occur. Herein, "substantially containing only the four ingredients (A) to (D)" means containing 10% by mass or less, more preferably 5% by mass or less, still more preferably 3% by mass or less, particularly preferably 1% by mass or less, and most preferably 0.5% by mass or less of ingredients other than the ingredients (A) to (D) in terms of the solid content of the total amount of the resin composition.

The resin composition of the present embodiment can be prepared by an ordinary method. As long as the method is a preparing method providing a resin composition uniformly containing the aliphatic epoxy-modified silicone compound (A), the multibranched imide resin (B), the titanium dioxide (C), the dispersing agent (D), and the other optional ingredients, the preparing method is not particularly limited. For example, the aliphatic epoxy-modified silicone compound, the multibranched imide resin, the titanium dioxide, the polymer wet dispersing agent having an acid radical, and the other inorganic filler are sequentially incorporated into the solvent, and the mixture is sufficiently stirred. Thereby, the resin composition of the present embodiment can be easily prepared.

An organic solvent can be used if necessary when the resin composition of the present embodiment is prepared. Any organic solvent may be used without particular limitation as long as the mixture of the aliphatic epoxy-modified silicone compound (A) and the multibranched imide resin (B) can be dissolved therein. The specific examples are previously described.

Known treatments (stirring, mixing, and kneading treatments or the like) can be performed to uniformly dissolve or disperse ingredients when the resin composition is prepared. For example, when the titanium dioxide (C) is uniformly dispersed, a stirring-dispersion treatment is performed by using a stirring vessel to which a stirrer having suitable stirring capability is attached, to improve the dispersibility of the titanium dioxide (C) for the resin composition. The stirring, mixing, and kneading treatments can be properly performed by using apparatuses aiming at mixing such as a ball mill and a bead mill, or known apparatuses such as revolution and rotation type mixing apparatuses.

On the other hand, a prepreg of the present embodiment may be obtained by combining the resin composition with a base material, specifically by impregnating or coating the base material with the resin composition. A method for producing the prepreg may be performed in accordance with an ordinary method without particular limitation. For example, the prepreg of the present embodiment can be produced by impregnating or coating the base material with the resin composition containing the aliphatic epoxy-modified silicone compound, the multibranched imide resin, the titanium dioxide, the polymer wet dispersing agent having an acid radical, and the inorganic filler, and thereafter heating the impregnated or coated base material in a drier of 100 to 200°C for 1 to 30 min to semi-cure (B-staging) the resin composition. The amount of the resin composition (including the titanium dioxide (C) and the other inorganic fillers) is preferably in the range of 30 to 90% by mass based on the total amount of the prepreg of the present embodiment without particular limitation.

The base material used in the present embodiment is not particularly limited. Known base materials used in various materials for printed wiring boards may be properly selected and used depending upon contemplated applications and performances. Specific examples thereof include, but are not particularly limited to, glass fibers such as E-glass, D-glass, S-glass, Q-glass, spherical glass, NE-glass, and T-glass fibers, inorganic fibers other than the glass fibers such as quartz fibers, and organic fibers such as polyimide, polyamide, and polyester fibers. The base materials may be used singly or in combinations of two or more. A woven cloth, a nonwoven cloth, a roving, a chopped strand mat, and a surfacing mat or the like are known as the shape of the base material. Plain weave, basket weave, and twill weave or the like are known as a method for weaving the woven cloth. These known products may be properly selected and used depending upon contemplated applications and performances. Products subjected to an open treatment and a glass woven fabric surface-treated by using a silane coupling agent or the like are suitably used. The thickness or mass of the base material is not particularly limited. Usually, the base material having a thickness of about 0.01 to 0.3 mm is suitably used. Especially, from the viewpoint of a strength and a water-absorbing property, the base material is preferably a glass woven fabric having a thickness of 200 µm or less and a mass of 250 g/m² or less, and more preferably a glass woven fabric made of a glass fiber of E-glass.

On the other hand, the metal foil-clad laminate of the present embodiment can be obtained by stacking one or more prepregs, disposing a metal foil on one side or both sides of the stack, and laminate-molding the one or more prepregs and the metal foil. Specifically, the metal foil-clad laminate of the present embodiment can be produced by stacking one or more prepregs, disposing a metal foil made of copper or aluminum or the like on one side or both sides of the stack if desired, and laminate-molding the one or more prepregs and the metal foil if necessary. Any metal foil used for the materials for printed wiring boards may be used herein without particular limitation, and known copper foils such as a rolled copper foil and an electrolytic copper foil are preferable. The thickness of the metal foil is not particularly limited. The thickness is preferably 2 to 70 µm, and more preferably 2 to 35 µm. A method and condition for molding the metal foil-clad laminate are not particularly limited. Techniques and conditions for conventional laminates for printed wiring boards and multilayer boards can be applied. For example, when the metal foil-clad laminate is molded, a multistage pressing machine, a multistage vacuum pressing machine, a continuous molding machine, and an autoclave molding machine or the like can be used. The lamination molding is generally carried out in the ranges of a temperature of 100 to 300°C, a planar pressure of 2 to 100 kgf/cm², and a heating time of 0.05 to 5 hr. Furthermore, postcuring may also be performed at a temperature of 150 to 300°C if necessary. A multilayer board can be formed by lamination molding of a combination of the prepreg of the present embodiment with a separately provided wiring board for an internal layer.

The metal foil-clad laminate of the present embodiment may be suitably used as the printed wiring board by forming a predetermined wiring pattern. Because the metal foil-clad laminate of the present embodiment has high optical reflectance in the ultraviolet light region and the visible light region, undergoes less deterioration in optical reflectance when subjected to the heat treatment and the light irradiation treatment, has the improved peel strength to the metal foil, and has the excellent heat resistance, the metal foil-clad laminate may be used especially effectively for the LED-mounting printed wiring board requiring such performances.

### Examples

Hereinafter, the present invention will be described in detail with reference to examples, comparative preparation examples, and comparative examples. However, the present invention is not limited to these examples in any way. Hereinafter, unless otherwise noted, "part" represents "part by mass".

### (Example 1)

45 parts by mass of a multibranched imide resin (V-8002 manufactured by DIC Corporation), 55 parts by mass of an aliphatic epoxy-modified silicone compound (X-40-2670 manufactured by Shin-Etsu Chemical Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), and 1.75 parts by mass of a dispersing agent (BYK-W903 manufactured by BYK Japan K.K.) were stirred and mixed in a homomixer, to obtain a varnish.

The varnish was diluted to 0.6 times with respect to the mass with methyl ethyl ketone. A 0.08 mm-thick E-glass cloth was impregnated with the diluted varnish. The E-glass cloth was heated at 150°C for 3 min, to obtain a prepreg having a resin composition content of 48% by mass.

Next, the two prepregs were stacked, and 12 µm-thick electrolytic copper foils (a JTC-LPZ foil manufactured by Nikko Materials Co., Ltd.) were disposed on both upper and lower sides of the stack. The copper foils and the stack were pressure-molded by using a vacuum pressing machine under conditions of a temperature of 220°C, a planar pressure of 30 kgf/cm², a vacuum of 30 mmHg or less, and a time of 150 min, to obtain a 0.2mm-thick double-sided copper-clad laminate.

### (Example 2)

A varnish was prepared in the same manner as in example 1 except that 45 parts by mass of the amount of the multibranched imide resin to be incorporated was replaced with 50 parts by mass; and 50 parts by mass of an aliphatic epoxy-modified silicone compound (SE-02CM manufactured by Nagase ChemteX Corporation) was used instead of 55 parts by mass of the aliphatic epoxy-modified silicone compound (X-40-2670 manufactured by Shin-Etsu Chemical Co., Ltd.). Similarly, a prepreg and a double-sided copper-clad laminate were obtained.

### (Example 3)

A varnish was prepared in the same manner as in example 1 except that 45 parts by mass of the amount of the multibranched imide resin to be incorporated was replaced with 50 parts by mass; 55 parts by mass of the aliphatic epoxy-modified silicone compound (X-40-2670) was replaced with 25 parts by mass; and 25 parts by mass of SE-02CM used in example 2 was further incorporated as the aliphatic epoxy-modified silicone compound. Similarly, a prepreg and a double-sided copper-clad laminate were obtained.

### (Comparative Preparation Example 1)

Into a five-necked 300 ml glass round bottom flask equipped with semicircular stainless-steel agitating blades, a nitrogen duct, a Dean-Stark with cooling tube, a thermometer, and a glass end cap, 100 g of 1,2,4-cyclohexanetricarboxylic acid-1,2-anhydride (H-TMAn manufactured by Mitsubishi Gas Chemical Co., Inc.) and 100 g of methyl ethyl ketone were added all together. The flask was then heated on a mantle heater to raise a temperature within a reaction system to 80°C over about 10 min. The mixture was stirred for 60 min to form a uniform solution. The solution was air-cooled to 50°C in about 10 min, to obtain a solution having a solid content concentration of 50% by mass.

### (Comparative Example 1)

42 parts by mass of bisphenol A-based cyanate (a prepolymer of 2,2-bis(4-cyanatephenyl)propane, CA210, manufactured by Mitsubishi Gas Chemical Co., Inc.) as a resin ingredient, 58 parts by mass of the aliphatic epoxy-modified silicone compound used in example 1, 75 parts by mass of the titanium dioxide used in example 1, 1.75 parts by mass of the dispersing agent used in example 1, and 0.15 part by mass of zinc octoate were stirred and mixed in a homomixer, to obtain a varnish. A prepreg and a double-sided copper-clad laminate were obtained in the same manner as in example 1 except for using this varnish.

### (Comparative Example 2)

22 parts by mass of a phenol novolac resin (TD2090 manufactured by DIC Corporation) represented by the following formula (7) as a resin ingredient, 78 parts by mass of the aliphatic epoxy-modified silicone compound used in example 1, 75 parts by mass of the titanium dioxide used in example 1, 1.75 parts by mass of the dispersing agent used in example 1, and 0.01 part by mass of 2-ethyl-4-methylimidazole (2E4MZ manufactured by Shikoku Chemicals Corporation) were stirred and mixed in a homomixer, to obtain a varnish. A prepreg and a double-sided copper-clad laminate were obtained in the same manner as in example 1 except for using this varnish. 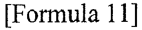 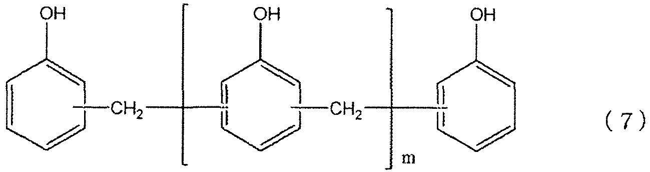 wherein m is a positive integer.

### (Comparative Example 3)

20 parts by mass of a solution of 1,2,4-cyclohexanetricarboxylic acid-1,2-anhydride (10 parts by mass as 1,2,4-cyclohexanetricarboxylic acid-1,2-anhydride) obtained in comparative preparation example 1, 90 parts by mass of the aliphatic epoxy-modified silicone compound used in example 1, 75 parts by mass of the titanium dioxide used in example 1, and 1.75 parts by mass of the dispersing agent used in example 1 were stirred and mixed in a homomixer, to obtain a varnish. A prepreg and a double-sided copper-clad laminate were obtained in the same manner as in example 1 except for using this varnish.

### (Comparative Example 4)

45 parts by mass of an aromatic imide resin (V-8000 manufactured by DIC Corporation), 55 parts by mass of the aliphatic epoxy-modified silicone compound used in example 1, 75 parts by mass of the titanium dioxide used in example 1, and 1.75 parts by mass of the dispersing agent used in example 1 were stirred and mixed in a homomixer, to obtain a varnish. A prepreg and a double-sided copper-clad laminate were obtained in the same manner as in example 1 except for using this varnish.

### (Comparative Example 5)

35 parts by mass of the multibranched imide resin used in example 1, 65 parts by mass of an aromatic epoxy-modified silicone compound (X-41-1053 manufactured by Shin-Etsu Chemical Co., Ltd.), 75 parts by mass of the titanium dioxide used in example 1, and 1.75 parts by mass of the dispersing agent used in example 1 were stirred and mixed in a homomixer, to obtain a varnish. A prepreg and a double-sided copper-clad laminate were obtained in the same manner as in example 1 except for using this varnish.

### (Comparative Example 6)

35 parts by mass of the multibranched imide resin used in example 1, 65 parts by mass of an aliphatic methacrylic-modified silicone resin (X-40-9272B manufactured by Shin-Etsu Chemical Co., Ltd.), 75 parts by mass of the titanium dioxide used in example 1, and 1.75 parts by mass of the dispersing agent used in example 1 were stirred and mixed in a homomixer, to obtain a varnish. A prepreg and a double-sided copper-clad laminate were obtained in the same manner as in example 1 except for using this varnish.

### (Comparative Example 7)

40 parts by mass of the multibranched imide resin used in example 1, 60 parts by mass of an aliphatic acrylic-modified silicone resin (KR-513 manufactured by Shin-Etsu Chemical Co., Ltd.), 75 parts by mass of the titanium dioxide used in example 1, and 1.75 parts by mass of the dispersing agent used in example 1 were stirred and mixed in a homomixer, to obtain a varnish. A prepreg and a double-sided copper-clad laminate were obtained in the same manner as in example 1 except for using this varnish.

### (Comparative Example 8)

20 parts by mass of the multibranched imide resin used in example 1, 80 parts by mass of an aromatic epoxy-modified silicone resin (KHE-2033 manufactured by Nippon Kayaku Co., Ltd.), 75 parts by mass of the titanium dioxide used in example 1, and 1.75 parts by mass of the dispersing agent used in example 1 were stirred and mixed in a homomixer, to obtain a varnish. A prepreg and a double-sided copper-clad laminate were obtained in the same manner as in example 1 except for using this varnish.

The prepregs and the copper-clad laminates of examples 1 to 3 and comparative examples 1 to 8 obtained as described above were measured and evaluated for prepreg external appearance, copper-clad laminate external appearance, reflectance, reflectance after heating, reflectance after a light treatment, Tg, a peel strength, and solder heat resistance.

A measuring method and evaluation method of each test method are as follows.

### (Measuring Methods)

1) Prepreg External Appearance: the tackiness on the surface of the obtained prepreg was confirmed by fingering.
2) Copper-clad Laminate Internal Appearance: the obtained double-sided copper-clad laminate was cut into a size of 50 × 50 mm with a dicing saw, and the section of the double-sided copper-clad laminate was then polished using a polishing machine, to obtain a measuring sample. The section state of the measuring sample was observed using a light microscope.
3) Reflectance: the copper-clad laminate was cut into a size of 50 × 50 mm with a dicing saw, and the copper foil of the surface was then removed by etching, to obtain a measuring sample. The measuring sample was measured for reflectance at 457 nm using a spectrophotometer (CM3610d manufactured by Konica Minolta Holdings, Inc.) based on JIS Z-8722 (average value of n = 5).
4) Reflectance after Heating: the sample obtained in the item 3) was heat-treated in a hot air drier of 180°C for 24 hr, and the sample was then measured for reflectance in the same manner as in the above measurement of the reflectance (average value of n = 5).
(5) Reflectance after Light Irradiation: the sample obtained in the item 3) was subjected to a light irradiation treatment under condition of 100 mW/cm² of ultraviolet ray (wavelength: 295 to 450 nm) irradiation intensity in a weatherometer drier (SUV-F11 manufactured by Iwasaki Electric Co., Ltd.) for 24 hr. The reflectance was then measured in the same manner as in the measurement of the reflectance (average value of n = 5).
6) Peel Strength: the obtained double-sided copper-clad laminate was cut into a size of 10 × 100 mm with a dicing saw, and the copper foil of the surface was then left, to obtain a measuring sample. The measuring sample was measured for the tear-off strength of the copper foil based on JIS C6481 using an autograph (AG-IS manufactured by Shimadzu Corporation) (average value of n = 5).
7) Tg: the double-sided copper-clad laminate was cut into a size of 12.7 × 2.5 mm with a dicing saw, and the copper foil of the surface was then removed by etching, to obtain a measuring sample. The measuring sample was measured for a glass transition temperature by a DMA method (average value of n = 3).
8) Solder Heat Resistance: the obtained double-sided copper-clad laminate was cut into a size of 50 × 50 mm with a dicing saw, and the copper foil of the surface was then left, to obtain a measuring sample. The measuring sample was immersed in a soldering vessel of 280°C for 30 min, and the change in external appearance of the measuring sample was then visually observed (the occurrence number of swellings/the number of tests: n = 3).

Evaluation results are shown in Tables 1 and 2.

**[Table 1]**

| | Example 1 | Example 2 | Example 3 |
|---|---|---|---|
| Prepreg external appearance | No tackiness | No tackiness | No tackiness |
| Copper-clad laminate internal appearance | No problem | No problem | No problem |
| Reflectance (%) | 91 | 91 | 91 |
| Reflectance after heating (%) | 80 | 77 | 78 |
| Reflectance after light irradiation (%) | 91 | 90 | 91 |
| Peel strength (gf/cm) | 700 | 500 | 600 |
| Tg (°C) | 190 | 185 | 185 |
| Solder heat resistance | 0/3 | 0/3 | 0/3 |

**[Table 2]**

| | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|
| PP external appearance | Tackiness | Tackiness | Tackiness | No tackiness | Tackiness | No tackiness | No tackiness | No tackiness |
| CCL internal appearance | Defective dispersion of resin and titanium dioxide | Defective dispersion of resin and titanium dioxide | Defective flowability of prepreg lamination interface | Defective flowability of prepreg lamination interface | Void | Void | Void | Void |
| Reflectance (%) | 82 | 78 | 90 | 89 | 88 | 87 | 89 | 90 |
| Reflectance after heating (%) | 58 | 24 | 79 | 84 | 74 | 62 | 73 | 84 |
| Reflectance after light irradiation (%) | 71 | 68 | 89 | 85 | 87 | 86 | 86 | 90 |
| Peel strength (gf/cm) | 600 | 590 | 290 | 340 | 50 | 60 | 80 | 120 |
| Tg(°C) | 190 | 175 | 165 | 215 | 275 | 255 | 255 | 275 |
| Solder heat resistance | 3/3 | 0/3 | 3/3 | 3/3 | 3/3 | 3/3 | 3/3 | 1/3 |

From Tables 1 and 2, it was confirmed that all the double-sided copper-clad laminates of examples 1 to 3 have high reflectance, undergo less deterioration in optical reflectance when subjected to the heat treatment and the light irradiation treatment, have an improved peel strength to the copper foil, and have excellent heat resistance. It was confirmed that the combination use of the aliphatic epoxy-modified silicone compound (A) and the multibranched imide resin (B) having an isocyanurate ring and a carboxyl group improves a peel strength, Tg, and heat resistance without causing the abnormalities of the external appearances of the prepreg and the double-sided copper-clad laminate.

As described above, the present invention is not limited to the above-mentioned embodiment and examples, and modifications can be properly made in a scope that does not depart from the gist of the present invention.

### Industrial Applicability

As described above, the present invention can be widely and effectively utilized in various applications such as electrical and electronic materials, a machine tool material, and an aviation material which require heat resistance and light resistance. Especially, the present invention can be effectively utilized in fields such as a printed wiring board and an LED-mounting printed wiring board which require particularly excellent light resistance and heat resistance, and a high peel strength to a metal foil.

The present application claims priority from Japanese Patent Application (Japanese Patent Application No. 2011-121924) filed to the Japan Patent Office on May 31, 2011, the contents of which are hereby incorporated by reference.

## Claims

1. A resin composition comprising:
an aliphatic epoxy-modified silicone compound (A);
a multibranched imide resin (B) having an isocyanurate ring and a carboxyl group;
titanium dioxide (C); and
a dispersing agent (D).

2. The resin composition according to claim 1, wherein the aliphatic epoxy-modified silicone compound (A) is a silicone compound having a repeating unit represented by the following formula (1), having at least three R's per molecule, and containing no alkoxy group: 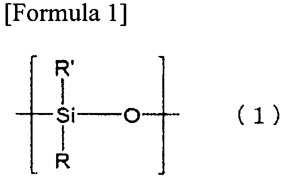 wherein R is a hydrogen atom, or a substituted or unsubstituted univalent hydrocarbon group, and R' is an organic group having an epoxy group.

3. The resin composition according to claim 1 or 2, wherein the multibranched imide resin (B) is represented by the following formula (6): 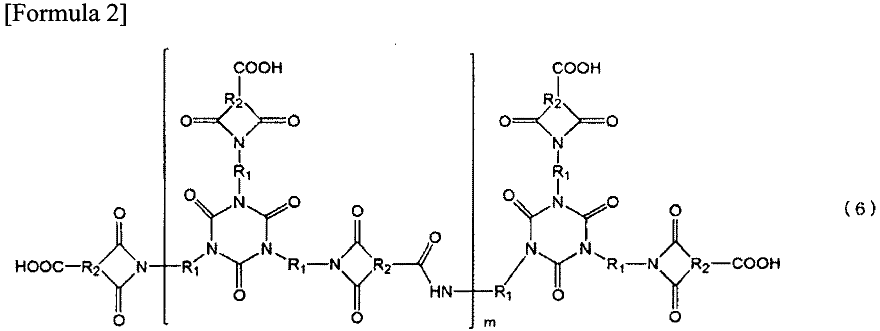 wherein each R₁ is independently a divalent alicyclic group; each R₂ is independently a trivalent alicyclic group; and m is an integer of 1 to 10.

4. The resin composition according to any one of claims 1 to 3, wherein a content of the aliphatic epoxy-modified silicone compound (A) is 20 to 90 parts by mass based on 100 parts by mass in total of the aliphatic epoxy-modified silicone compound (A) and the multibranched imide resin (B).

5. The resin composition according to any one of claims 1 to 4, wherein a content of the multibranched imide resin (B) is 10 to 80 parts by mass based on 100 parts by mass in total of the aliphatic epoxy-modified silicone compound (A) and the multibranched imide resin (B).

6. The resin composition according to any one of claims 1 to 5, wherein a content of the titanium dioxide (C) is 10 to 250 parts by mass based on 100 parts by mass in total of the aliphatic epoxy-modified silicone compound (A) and the multibranched imide resin (B).

7. The resin composition according to any one of claims 1 to 6, wherein the titanium dioxide (C) is surface-treated with SiO₂, Al₂O₃, ZrO₂, and/or ZnO; and the total amount of 100 parts by mass of the titanium dioxide (C) comprises 0.5 to 15 parts by mass of SiO₂, 0.5 to 15 parts by mass of Al₂O₃, 0.5 to 15 parts by mass of ZrO₂, and/or 0.5 to 15 parts by mass of ZnO.

8. The resin composition according to any one of claims 1 to 7, wherein the dispersing agent (D) is a polymer wet dispersing agent having an acid value of 20 to 200 mgKOH/g.

9. The resin composition according to any one of claims 1 to 8, wherein a content of the dispersing agent (D) is 0.05 to 5 parts by mass based on 100 parts by mass in total of the aliphatic epoxy-modified silicone compound (A) and the multibranched imide resin (B).

10. The resin composition according to any one of claims 1 to 9 for an LED-mounting printed wiring board.

11. A prepreg prepared by impregnating or coating a base material with the resin composition according to any one of claims 1 to 10.

12. A metal foil-clad laminate obtained by stacking one or more prepregs according to claim 11, and disposing a metal foil on one side or both sides of the stack, and laminate-molding the one or more prepregs and the metal foil.

## Patentansprüche

1. Harzzusammensetzung, umfassend:
eine mit aliphatischem Epoxy-modifizierte Silikonverbindung (A);
ein mehrfach verzweigtes Imidharz (B), das einen Isocyanuratring und eine Carboxylgruppe aufweist;
Titandioxid (C); und
ein Dispergiermittel (D).

2. Harzzusammensetzung gemäß Anspruch 1, worin die mit aliphatischem Epoxy-modifizierte Silikonverbindung (A) eine Silikonverbindung ist, die eine durch die folgende Formel (1) dargestellte Wiederholungseinheit aufweist, zumindest drei R pro Molekül aufweist und keine Alkoxygruppe enthält: 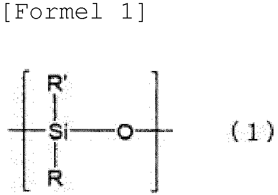 worin R ein Wasserstoffatom oder eine substituierte oder unsubstituierte univalente Kohlenwasserstoffgruppe ist und R' eine organische Gruppe, die eine Epoxygruppe aufweist, ist.

3. Harzzusammensetzung gemäß Anspruch 1 oder 2, worin das mehrfach verzweigte Imidharz (B) durch die folgende Formel (6) dargestellt wird: 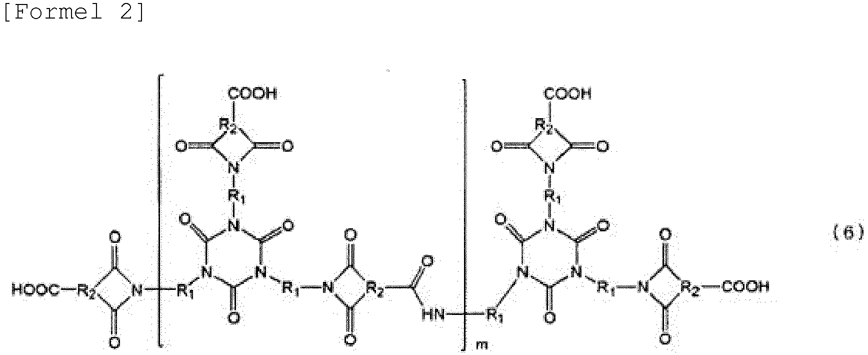 worin jedes R₁ unabhängig eine divalente alicyclische Gruppe ist; jedes R₂ unabhängig eine trivalente alicyclische Gruppe ist; und m eine ganze Zahl von 1 bis 10 ist.

4. Harzzusammensetzung gemäß irgendeinem der Ansprüche 1 bis 3, worin der Mengenanteil der mit aliphatischem Epoxy-modifizierten Silikonverbindung (A) 20 bis 90 Masseteile beträgt, bezogen auf 100 Masseteile der Gesamtheit der mit aliphatischem Epoxy-modifizierten Silikonverbindung (A) und des mehrfach verzweigten Imidharzes (B).

5. Harzzusammensetzung gemäß irgendeinem der Ansprüche 1 bis 4, worin der Mengenanteil des mehrfach verzweigten Imidharzes (B) 10 bis 80 Masseteile beträgt, bezogen auf 100 Masseteile der Gesamtheit der mit aliphatischem Epoxy-modifizierten Silikonverbindung (A) und des mehrfach verzweigten Imidharzes (B).

6. Harzzusammensetzung gemäß irgendeinem der Ansprüche 1 bis 5, worin der Mengenanteil des Titandioxids (C) 10 bis 250 Masseteile beträgt, bezogen auf 100 Masseteile der Gesamtheit der mit aliphatischem Epoxy-modifizierten Silikonverbindung (A) und des mehrfach verzweigten Imidharzes (B).

7. Harzzusammensetzung gemäß irgendeinem der Ansprüche 1 bis 6, worin das Titandioxid (C) mit SiO₂, Al₂O₃, ZrO₂ und/oder ZnO oberflächenbehandelt ist; und worin die Gesamtmenge von 100 Masseteilen des Titandioxids (C) 0,5 bis 15 Masseteile SiO₂, 0,5 bis 15 Masseteile Al₂O₃, 0,5 bis 15 Masseteile ZrO₂ und/oder 0,5 bis 15 Masseteile ZnO umfasst.

8. Harzzusammensetzung gemäß irgendeinem der Ansprüche 1 bis 7, worin das Dispergiermittel (D) ein Polymer-Nassdispergiermittel mit einem Säurewert von 20 bis 200 mgKOH/g ist.

9. Harzzusammensetzung gemäß irgendeinem der Ansprüche 1 bis 8, worin der Mengenanteil des Dispergiermittels (D) 0,05 bis 5 Masseteile beträgt, bezogen auf 100 Masseteile der Gesamtheit der mit aliphatischem Epoxy-modifizierten Silikonverbindung (A) und des mehrfach verzweigten Imidharzes (B).

10. Harzzusammensetzung gemäß irgendeinem der Ansprüche 1 bis 9 für eine LED-tragende Platine.

11. Prepreg, hergestellt durch Imprägnieren oder Beschichten eines Basismaterials mit der Harzzusammensetzung gemäß irgendeinem der Ansprüche 1 bis 10.

12. Mit Metallfolie kaschiertes Laminat, erhalten durch Stapeln von einem oder mehrerer Prepregs gemäß Anspruch 11 und Anordnen einer Metallfolie auf einer Seite oder beiden Seiten des Stapels, und Laminat-Formen des einen oder der mehreren Prepregs und der Metallfolie.

## Revendications

1. Composition de résine comprenant :
un composé de silicone aliphatique à modification époxy (A) ;
une résine d'imide multiramifié (B) ayant un cycle isocyanurate et un groupe carboxyle ;
du dioxyde de titane (C) ; et
un agent de dispersion (D).

2. Composition de résine selon la revendication 1, dans laquelle le composé de silicone aliphatique à modification époxy (A) est un composé de silicone ayant un motif répétitif représenté par la formule (1) suivante, ayant au moins trois R' par molécule et ne contenant pas de groupes alcoxy : 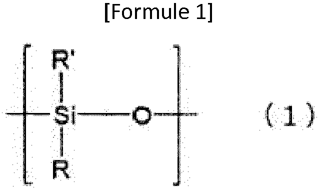 dans laquelle R est un atome d'hydrogène, ou un groupe hydrocarboné univalent substitué ou non substitué, et R' est un groupe organique ayant un groupe époxy.

3. Composition de résine selon la revendication 1 ou 2, dans laquelle la résine d'imide multiramifié (B) est représentée par la formule (6) suivante : 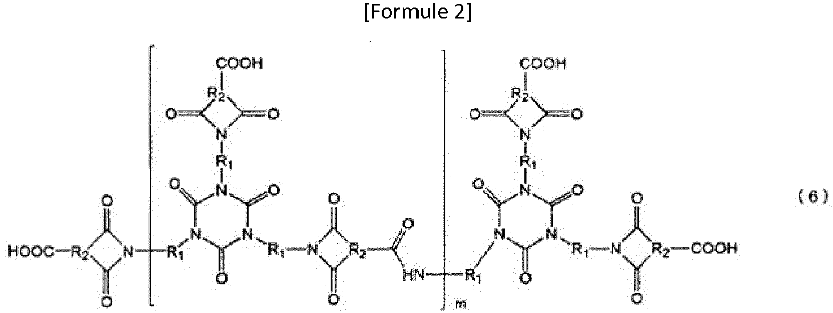 dans laquelle chaque R₁ est indépendamment un groupe alicyclique divalent; chaque R₂ est indépendamment un groupe alicyclique trivalent; et m est un nombre entier allant de 1 à 10.

4. Composition de résine selon l'une quelconque des revendications 1 à 3, dans laquelle une teneur du composé de silicone aliphatique à modification époxy (A) est de 20 à 90 parties en masse sur la base de 100 parties en masse au total du composé de silicone aliphatique à modification époxy (A) et de la résine d'imide multiramifié (B).

5. Composition de résine selon l'une quelconque des revendications 1 à 4, dans laquelle une teneur de la résine d'imide multiramifié (B) est de 10 à 80 parties en masse sur la base de 100 parties en masse au total du composé de silicone aliphatique à modification époxy (A) et de la résine d'imide multiramifié (B).

6. Composition de résine selon l'une quelconque des revendications 1 à 5, dans laquelle une teneur du dioxyde de titane (C) est de 10 à 250 parties en masse sur la base de 100 parties en masse au total du composé de silicone aliphatique à modification époxy (A) et de la résine d'imide multiramifié (B).

7. Composition de résine selon l'une quelconque des revendications 1 à 6, dans laquelle le dioxyde de titane (C) est traité en surface avec SiO₂, Al₂O₃, ZrO₂, et/ou ZnO ; et la quantité totale de 100 parties en masse du dioxyde de titane (C) comprend 0,5 à 15 parties en masse de SiO₂, 0,5 à 15 parties en masse de Al₂O₃, 0,5 à 15 parties en masse de ZrO₂, et/ou 0,5 à 15 parties en masse de ZnO.

8. Composition de résine selon l'une quelconque des revendications 1 à 7, dans laquelle l'agent de dispersion (D) est un agent de dispersion humide polymère présentant un indice d'acidité de 20 à 200 mg de KOH/g.

9. Composition de résine selon l'une quelconque des revendications 1 à 8, dans laquelle une teneur de l'agent de dispersion (D) est de 0,05 à 5 parties en masse sur la base de 100 parties en masse au total du composé de silicone aliphatique à modification époxy (A) et de la résine d'imide multiramifié (B).

10. Composition de résine selon l'une quelconque des revendications 1 à 9 pour une carte de circuit imprimée de montage de DEL.

11. Préimprégné préparé par l'imprégnation ou le revêtement d'un matériau de base avec la composition de résine selon l'une quelconque des revendications 1 à 10.

12. Stratifié recouvert d'une feuille de métal obtenu par l'empilement d'un ou de plusieurs préimprégnés selon la revendication 11, et la disposition d'une feuille de métal sur une face ou les deux faces de l'empilement, et le moulage sous forme de stratifié des un ou plusieurs préimprégnés et de la feuille de métal.
